# FASCICULE DE BREVET EUROPEEN

(11) **EP 3 144 977 B1**
(45) Date de publication et mention de la délivrance du brevet: **06.11.2019**
(21) Numéro de dépôt: 16156460.4
(22) Date de dépôt: 19.02.2016
(51) Int. Cl.: H01L 29/872, H01L 29/205, H01L 29/417, H01L 21/329

(54) **DIODE SCHOTTKY HAUTE TENSION À NITRURE DE GALLIUM**
HOCHSPANNUNGS-SCHOTTKY-DIODE AUS GALLIUMNITRID
HIGH-VOLTAGE GALLIUM NITRIDE SCHOTTKY DIODE

(30) Priorité: 28.08.2015 FR 1558035
(43) Date de publication de la demande: 22.03.2017
(73) Titulaire: STMicroelectronics (Tours) SAS, 37100 Tours (FR)
(72) Inventeur: YVON, Arnaud, 37540 SAINT-CYR-SUR-LOIRE (FR)
(74) Mandataire: Cabinet Beaumont

(56) Documents cités:
- JP-A- 2009 272 441
- US-A1- 2006 108 659
- US-A1- 2014 103 398
- US-B1- 8 088 660

## Description

### Domaine

La présente demande concerne les composants électroniques, et plus particulièrement des diodes Schottky à nitrure de gallium, GaN, susceptibles de fonctionner à haute tension et forte puissance.

### Exposé de l'art antérieur

Le brevet US 8791508 décrit des composants électroniques tels que des diodes et des transistors dans lesquels le courant principal circule latéralement dans une couche mince de nitrure de gallium-aluminium, AlGaN, formée sur une couche de GaN.

La figure 1A est une vue en coupe d'une portion de diode Schottky à GaN qui correspond à la figure 7 du brevet US 8791508. Un support 1 de silicium non dopé est recouvert d'une couche 3 de nitrure d'aluminium, d'une couche 5 de GaN non dopé, et d'une couche 7 d'AlGaN non dopé. Des métallisations 9 en palladium sont déposées sur la couche 7 et sont encadrées de métallisations 11 en titane-aluminium Ti-Al formées à travers la couche 7. Les métallisations 9 forment des contacts Schottky avec la couche d'AlGaN et les métallisations 11 sont en contact ohmique par leurs flancs avec la couche d'AlGaN. Des métallisations 15 en or sont déposées sur les métallisations 9 et des métallisations 17 en or sont déposées sur les métallisations 11. L'assemblage est recouvert d'une couche d'isolement 19.

La couche 7 d'AlGaN en liaison avec la couche 5 de GaN est apte à conduire un courant latéralement entre les métallisations Schottky 9 et ohmiques 11. Lorsque la diode est polarisée en direct, un courant s'écoule latéralement depuis les flancs des métallisations 11 vers la périphérie des métallisations 9.

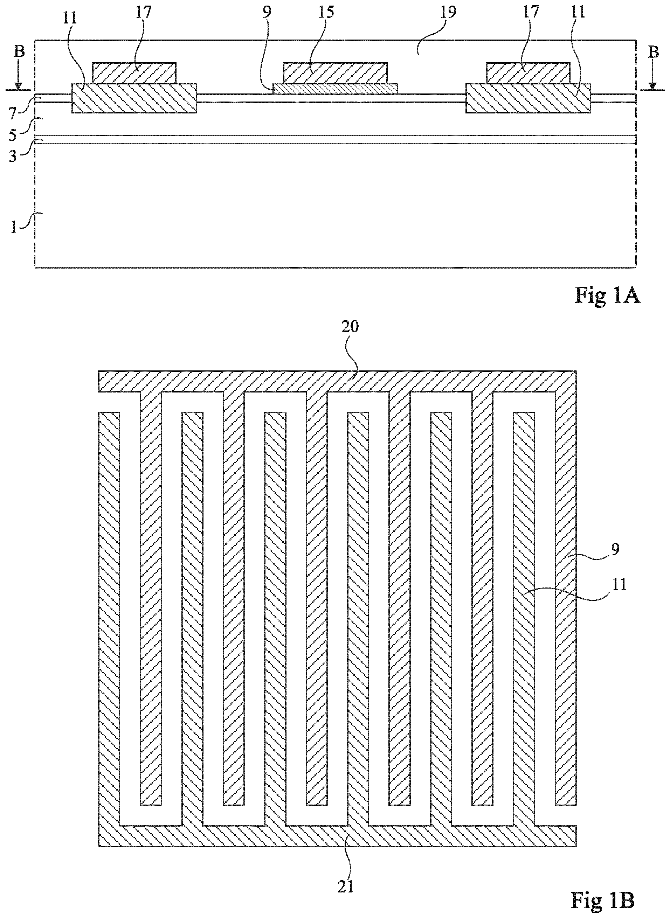

La figure 1B est un exemple de vue de dessus selon la coupe B-B de la figure 1A. Les métallisations 9 et 11 comprennent un ensemble de bandes parallèles alternées. Les bandes 9 constituent les dents d'un premier peigne, et les bandes 11 constituent les dents d'un deuxième peigne entrelacé avec le premier. Seules trois dents sont représentées en figure 1A, un plus grand nombre de dents étant représenté en figure 1B pour faciliter la compréhension. Chacun des peignes est connecté à une borne, 20, 21, de la diode.

Un problème est que, si les dents des peignes sont longues et étroites, une résistance non négligeable apparaît à l'état passant.

La demande de brevet US 2006/0108659 et la demande de brevet japonais 2009/272441 décrivent des diodes Schottky à GaN.

### Résumé

Pour résoudre les problèmes des diodes de l'art antérieur, la présente invention propose une diode Schottky selon la revendication 1.

Selon un mode de réalisation, les motifs sont répétés périodiquement.

Selon un mode de réalisation, la diode Schottky comprend en outre, entre le support de silicium et la couche de silicium non dopé, une couche d'oxyde de silicium.

Selon un mode de réalisation, les deuxièmes vias s'étendent jusqu'au support de silicium.

Selon un mode de réalisation, la diode Schottky comprend, dans la couche de silicium non dopé, des zones de silicium dopé en contact avec les deuxièmes vias.

Selon un mode de réalisation, la deuxième métallisation comprend des premiers îlots répétés périodiquement.

Selon un mode de réalisation, la première métallisation forme un réseau en nid d'abeilles.

Selon un mode de réalisation, la première métallisation comprend des deuxièmes îlots répétés périodiquement.

Selon un mode de réalisation, les premiers îlots et les deuxièmes îlots forment un motif en damier.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1A, décrite précédemment, est une vue partielle et en coupe d'une diode Schottky à GaN ;
la figure 1B, décrite précédemment, est une vue de dessus d'une diode Schottky à GaN ;
la figure 2 est une vue schématique partielle et en coupe d'un mode de réalisation d'une diode Schottky à GaN ;
la figure 3 est une vue de dessus d'un exemple de topologie de diode Schottky à GaN ;
la figure 4 est une vue de dessus d'un autre exemple de topologie de diode Schottky à GaN ; et
la figure 5 est une vue schématique partielle et en coupe d'un autre mode de réalisation d'une diode Schottky à GaN.

### Description détaillée

De mêmes éléments ont été désignés par de mêmes références aux différentes figures et, de plus, les diverses figures ne sont pas tracées à l'échelle. Par souci de clarté, seuls les éléments qui sont utiles à la compréhension des modes de réalisation décrits ont été représentés et sont détaillés.

Dans la description qui suit, lorsque l'on fait référence à des qualificatifs de position absolue, tels que les termes "haut", "bas", etc., ou relative, tels que les termes "dessus", "supérieur", "inférieur", etc., ou à des qualificatifs d'orientation, tels que les termes "horizontal", "vertical", etc., il est fait référence à l'orientation des vues en coupe.

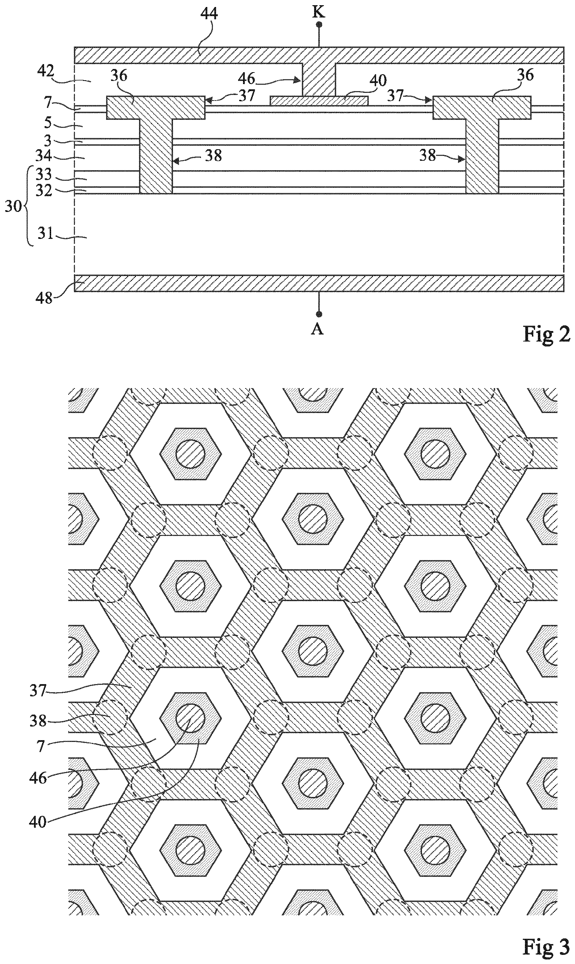

La figure 2 est une vue schématique partielle et en coupe d'un mode de réalisation d'une diode Schottky à GaN.

Pour réaliser la structure de la figure 2, on peut partir d'une plaquette 30 de type silicium sur isolant (SOI), constituée d'un support 31 de silicium dopé de type P, recouverte d'une couche 32 d'oxyde de silicium, sur laquelle se trouve une couche 33 de silicium. Sur la couche 33, on fait croître par épitaxie une couche 34 de silicium non dopé dont la fonction sera explicitée ci-après. Après cela, une couche 3 de nitrure d'aluminium, AlN, est déposée par épitaxie sur la couche 34 de silicium non dopé. Cette couche 3 sert de couche d'interface pour l'épitaxie d'une couche 5 en GaN non dopé, sur laquelle est déposée par épitaxie une couche 7 d'AlGaN non dopé.

Des zones conductrices 36, dont seulement deux sont représentées, sont ensuite réalisées. Chaque zone conductrice comprend une portion supérieure ou métallisation 37 dont le niveau atteint ou dépasse la surface de la couche 7 d'AlGaN et qui s'étend à travers la couche 7 dans une partie de la couche 5 de GaN. De cette manière, chacune des métallisations 37 est en contact ohmique avec la couche 7 par ses flancs. Chaque zone conductrice 36 comprend aussi une portion verticale ou via 38 qui s'étend à partir d'une partie centrale de la portion supérieure à travers les couches 5, 3, 34, 33 et 32 et rejoint le support 31. Les zones conductrices 36 sont par exemple en Ti-Al.

Des métallisations 40, dont une seule est représentée, faisant contact Schottky avec la couche 7 d'AlGaN, sont ensuite déposées sur la couche 7 entre les métallisations 37. La surface de l'assemblage est alors revêtue d'une couche d'isolement 42, par exemple de l'oxyde de silicium ou du nitrure de silicium. Des ouvertures sont gravées à travers la couche d'isolement 42 jusqu'aux métallisations 40. Une métallisation 44, remplissant ces ouvertures et recouvrant la surface du dispositif, est réalisée. Les ouvertures remplies de métal forment des vias 46 reliant les métallisations Schottky 40 à la métallisation 44. Les métallisations 40 sont par exemple en platine ou palladium ou nickel ou nickel-or.

Une métallisation 48 en contact avec le support 31 de silicium dopé est réalisée sur la face inférieure de la plaquette 30. Les métallisations 44 et 48 peuvent être en cuivre ou en aluminium et peuvent recouvrir l'ensemble des surfaces inférieure et supérieure de la diode, afin de réduire la résistance d'accès de la cathode et de l'anode. Les métallisations 44 et 48 sont respectivement reliées à des bornes de cathode et d'anode K et A.

A l'état passant, un courant issu de la borne A s'écoule depuis le support 31 de silicium dopé et les vias 38 vers les métallisations 37. Le courant circule ensuite horizontalement, ou latéralement, dans la couche 7 d'AlGaN en liaison avec la couche 5 de GaN, jusqu'aux métallisations Schottky 40, puis se propage dans les vias 46 pour atteindre la borne K.

A l'état bloqué, la tension appliquée entre les bornes K et A peut atteindre plusieurs centaines de volts. Les couches isolantes présentes entre le support conducteur 31 connecté à la borne A et la métallisation 40 connectée à la borne K sont soumises à cette tension. La couche isolante 34 en silicium non dopé ajoute une épaisseur supplémentaire aux couches 3, 5 et 7, améliorant ainsi la tenue en tension.

En vue de dessus, les métallisations Schottky 40 et ohmiques 37 peuvent correspondre à des dents parallèles et alternées, de façon similaire à ce qui a été décrit en relation avec la figure 1B. Chaque dent Schottky 40 est alors reliée à la métallisation 44 par plusieurs vias 46 disposés régulièrement. Chaque dent ohmique est de même reliée au support 31 par plusieurs vias.

Les vias 38 appliquent le potentiel de la borne A en plusieurs points de chaque dent ohmique 37. De même, les vias 46 appliquent le potentiel de la borne K en plusieurs points de chaque dent Schottky. Il est clair que la présence des multiples vias 38 et 46 permet de limiter la résistance d'accès à la diode.

La figure 3 est une vue de dessus d'un autre exemple de topologie de diode Schottky à GaN correspondant à la vue en coupe de la figure 2. Cette vue de dessus est réalisée en l'absence de la couche isolante 42 et de la métallisation supérieure 44. Bien que seules trois métallisations aient été représentées en figure 2, un plus grand nombre de métallisations est représenté en figure 3 afin de faciliter la compréhension.

Les métallisations ohmiques 37 forment un réseau continu d'hexagones réguliers en nid d'abeilles. Dans l'exemple représenté, des vias 38 cylindriques, représentés en pointillés, se situent aux noeuds du réseau. Au centre de chacun des hexagones se trouve un îlot de métallisation Schottky 40 hexagonal de même orientation que celle des hexagones du réseau. Chaque îlot 40 est en contact dans sa partie centrale avec un via 46. Ainsi, une couronne de la couche 7 est présente entre chaque îlot Schottky 40 et la métallisation ohmique 37 qui l'entoure.

D'après des simulations numériques effectuées par l'inventeur, cette configuration minimise la surface de la diode. En outre, cette configuration permet de limiter la surface et le coût des métallisations Schottky.

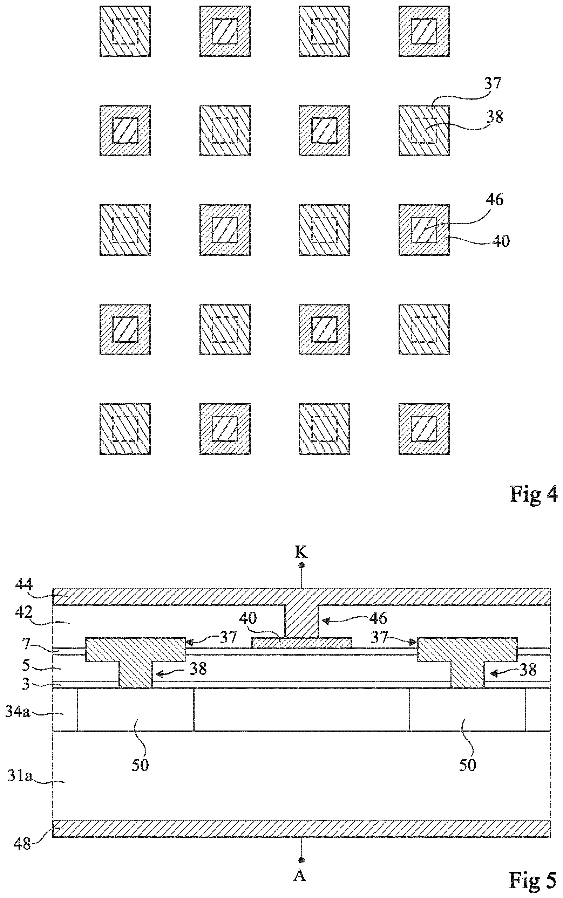

La figure 4 est une vue de dessus d'un autre exemple de topologie de diode Schottky à GaN correspondant à la vue en coupe de la figure 2.

Les métallisations Schottky 37 et les métallisations ohmiques 40 sont des îlots de forme carrée et de mêmes dimensions qui forment deux ensembles disposés selon un motif en damier. Chacun des îlots 36 et 40 occupe une partie centrale de chaque case, non représentée, du damier. Les vias 38 se trouvent au centre des îlots 37 et les vias 46 sont en contact avec la partie centrale des îlots 40. Cette topologie s'avère plus efficace que celle à bandes parallèles.

La figure 5 est une vue schématique partielle et en coupe d'un autre mode de réalisation d'une diode Schottky à GaN. Pour réaliser la structure de la figure 5, on part d'un substrat massif de silicium dopé, et non d'une plaquette SOI.

Sur un substrat 31a de silicium dopé de type P, une couche 34a de silicium non dopé est formée par épitaxie. A une étape suivante, des zones 50 dopées du type P sont formées sur toute l'épaisseur de la couche 34a en regard des métallisations ohmiques 37.

La diode comprend, de bas en haut, une métallisation 48, le substrat 31a, la couche 34a avec les deux zones 50, une couche 3 d'AlN, une couche 5 de GaN, une couche 7 d'AlGaN, une couche d'isolement 42 et une métallisation 44. Des métallisations 37 se situent au-dessus des zones 50, au travers de la couche 7, entre un niveau situé dans la couche 5 et un niveau situé dans la couche 42. Les métallisations 37 sont reliées aux zones 50 par des vias 38 passant à travers les couches 3 et 5. Les métallisations Schottky 40 en contact avec la couche 7 se situent au niveau d'une partie inférieure de la couche 42. La métallisation 44 est en contact par des vias 46 avec les métallisations Schottky 40.

Les métallisations 37 sont ainsi connectées au substrat 31a par l'intermédiaire des vias 38 et des zones conductrices 50.

Les métallisations 44 et 48 peuvent être en cuivre ou en aluminium et peuvent recouvrir l'ensemble des surfaces inférieure et supérieure de la diode Schottky, afin de réduire la résistance d'accès de la cathode et de l'anode.

A titre de variante, les zones dopées 50 peuvent être omises dans la structure de la figure 5. Pour assurer le contact des métallisations 37 avec le substrat 31a, les vias 38 s'étendent alors à travers la couche 34a de silicium non dopé.

Un avantage des diodes Schottky selon les modes de réalisation décrits ci-dessus est que la résistance est faible à l'état passant.

Un autre avantage est que la surface du composant est diminuée, car aucune place supplémentaire n'est requise pour réaliser des plots de contact.

Un autre avantage est que la prévision d'une couche de silicium non dopé 34, 34a sur un support 31, 31a de silicium dopé fournit une structure moins fragile (moins cassante) que quand le support est entièrement du silicium non dopé. De ce fait, la couche 5 de GaN peut être plus épaisse sans que les processus thermiques liés à son épitaxie risquent de rompre le support.

Des modes de réalisation particuliers ont été décrits. Diverses variantes et modifications apparaîtront à l'homme de l'art. En particulier, bien que des motifs périodiques particuliers répétés selon des réseaux hexagonaux et carrés aient été décrits en relation avec les figures 3 et 4, il est clair que d'autres motifs, de préférence périodiques, peuvent être prévus.

Bien que les structures décrites soient réalisées à partir de supports de silicium dopé de type P, des structures identiques peuvent être réalisées à partir de supports dopés de type N.

## Revendications

1. Diode Schottky comprenant, entre une face inférieure et une face supérieure :
un support de silicium (31, 31a) dopé ;
une couche de GaN non dopé (5) ;
une couche d'AlGaN (7) formée sur la couche de GaN ;
des premières métallisations (37) formant des contacts ohmiques avec la couche d'AlGaN et des deuxièmes métallisations (40) formant des contacts Schottky avec la couche d'AlGaN, les premières et deuxièmes métallisations délimitant, en vue de dessus, un ou plusieurs motifs formés dans la couche d'AlGaN (7);
des premiers vias (46) s'étendant des deuxièmes métallisations (40) vers la face supérieure ;
des deuxièmes vias (38) s'étendant des premières métallisations (37) vers la face inférieure, les deuxièmes vias étant en contact électrique, direct ou indirect, avec le support de silicium ;
une métallisation (44) réalisée sur la face supérieure et reliée électriquement aux deuxièmes métallisations par les premiers vias ;
une métallisation (48) réalisée sur la face inférieure et en contact avec le support de silicium ;
la diode étant **caractérisée en ce qu'**elle comprend une couche de silicium (34, 34a) non dopé entre le support de silicium et la couche de GaN.

2. Diode Schottky selon la revendication 1, dans laquelle les motifs sont répétés périodiquement.

3. Diode Schottky selon la revendication 1 ou 2, comprenant en outre, entre le support de silicium (31, 31a) et la couche de silicium (34, 34a) non dopé, une couche d'oxyde de silicium (32).

4. Diode Schottky selon l'une quelconque des revendications 1 à 2, comprenant, dans la couche (34, 34a) de silicium non dopé, des zones (50) de silicium dopé en contact avec les deuxièmes vias (38).

5. Diode Schottky selon l'une quelconque des revendications 1 à 4, dans laquelle la deuxième métallisation (40) comprend des premiers îlots répétés périodiquement.

6. Diode Schottky selon la revendication 5, dans laquelle la première métallisation (37) forme un réseau en nid d'abeilles.

7. Diode Schottky selon la revendication 5, dans laquelle la première métallisation (37) comprend des deuxièmes îlots répétés périodiquement.

8. Diode Schottky selon la revendication 7, dans laquelle les premiers îlots et les deuxièmes îlots forment un motif en damier.

## Patentansprüche

1. Schottky-Diode, die zwischen einer Unterseite und einer Oberseite Folgendes umfasst:
einen dotierten Siliziumträger (31, 31a);
eine undotierte GaN-Schicht (5);
eine auf der GaN-Schicht ausgebildete AlGaN-Schicht (7);
erste Metallisierungen (37), die mit der AlGaN-Schicht ohmsche Kontakte bilden, und zweite Metallisierungen (40), die mit der AlGaN-Schicht Schottky-Kontakte bilden, wobei die ersten und zweiten Metallisierungen von oben gesehen ein oder mehrere in der AlGaN-Schicht (7) ausgebildete Muster begrenzen;
erste Durchkontaktierungen (46), die sich von den zweiten Metallisierungen (40) zur Oberseite erstrecken;
zweite Durchkontaktierungen (38), die sich von den ersten Metallisierungen (37) zur Unterseite erstrecken, wobei die zweiten Durchkontaktierungen in direktem oder indirektem elektrischem Kontakt mit dem Siliziumträger stehen;
eine auf der Oberseite ausgebildete Metallisierung (44), die anhand der ersten Durchkontaktierungen mit den zweiten Metallisierungen elektrisch verbunden ist;
eine auf der Unterseite ausgebildete Metallisierung (48), die mit dem Siliziumträger in Kontakt steht;
wobei die Diode **dadurch gekennzeichnet ist, dass** sie zwischen dem Siliziumträger und der GaN-Schicht eine undotierte Siliziumschicht (34, 34a) aufweist.

2. Schottky-Diode nach Anspruch 1, wobei sich die Muster periodisch wiederholen.

3. Schottky-Diode nach Anspruch 1 oder 2, die ferner zwischen dem Siliziumträger (31, 31a) und der undotierten Siliziumschicht (34, 34a) eine Siliziumoxidschicht (32) aufweist.

4. Schottky-Diode nach einem der Ansprüche 1 bis 2, die in der Schicht (34, 34a) aus undotiertem Silizium Zonen (50) aus dotiertem Silizium in Kontakt mit den zweiten Durchkontaktierungen (38) aufweist.

5. Schottky-Diode nach einem der Ansprüche 1 bis 4, wobei die zweite Metallisierung (40) erste Inseln aufweist, die sich periodisch wiederholen.

6. Schottky-Diode nach Anspruch 5, wobei die erste Metallisierung (37) ein Wabennetzwerk bzw. eine Wabenstruktur bildet.

7. Schottky-Diode nach Anspruch 5, wobei die erste Metallisierung (37) zweite Inseln aufweist, die sich periodisch wiederholen.

8. Schottky-Diode nach Anspruch 7, wobei die ersten Inseln und die zweiten Inseln ein Schachbrettmuster bilden.

## Claims

1. A Schottky diode comprising, between a lower surface and an upper surface:
a doped silicon support (31, 31a);
a non-doped GaN layer (5);
an AlGaN layer (7) formed on the GaN layer;
first metallizations (37) forming ohmic contacts with the AlGaN layer and second metallizations (40) forming Schottky contacts with the AlGaN layer, the first and second metallizations delimiting, in top view, one or several patterns formed in the AlGaN layer (7);
first vias (46) extending from the second metallizations (40) towards the upper surface;
second vias (38) extending from the first metallizations (37) towards the lower surface, the second vias being electrically in contact, directly or indirectly, with the silicon support;
a metallization (44) made on the upper surface and electrically connected to the second metallizations by the first vias;
a metallization (48) made on the lower surface and in contact with the silicon support;
the diode being **characterized in that** it comprises a non-doped silicon layer (34, 34a) between the silicon support and the GaN layer.

2. The Schottky diode of claim 1, wherein the patterns are periodically repeated.

3. The Schottky diode of claim 1 or 2, further comprising, between the silicon support (31, 31a) and the non-doped silicon layer (34, 34a), a silicon oxide layer (32).

4. The Schottky diode of any of claims 1 to 2, comprising, in the non-doped silicon layer (34, 34a), doped silicon areas (50) in contact with the second vias (38).

5. The Schottky diode of any of claims 1 to 4, wherein the second metallization (40) comprises periodically repeated first islands.

6. The Schottky diode of claim 5, wherein the first metallization (37) forms a honeycomb network.

7. The Schottky diode of claim 5, wherein the first metallization (37) comprises periodically repeated second islands.

8. The Schottky diode of claim 7, wherein the first islands and the second islands form a checkerboard pattern.
